(19) Europäisches Patentamt
European Patent Office
Office européen des brevets

(11) **EP 1 323 237 B1**

(12) **EUROPEAN PATENT SPECIFICATION**

(45) Date of publication and mention
of the grant of the patent:
**14.11.2018 Bulletin 2018/46**

(21) Application number: **01969015.5**

(22) Date of filing: **10.09.2001**

(51) Int Cl.:
*H04B 1/58* (2006.01)     *H03H 7/21* (2006.01)

(86) International application number:
**PCT/US2001/042114**

(87) International publication number:
**WO 2002/023749 (21.03.2002 Gazette 2002/12)**

(54) **SYSTEM FOR EIGHT-PHASE 45° POLYPHASE FILTER WITH AMPLITUDE MATCHING**

SYSTEM FÜR EIN ACHTPHASEN-45°-POLYPHASENFILTER MIT AMPLITUDENANPASSUNG

SYSTEME DE FILTRE HUIT PHASES 45° ACCORDABLES EN AMPLITUDE

(84) Designated Contracting States:
**AT BE CH CY DE DK ES FI FR GB GR IE IT LI LU MC NL PT SE TR**

(30) Priority: **18.09.2000 US 666501**

(43) Date of publication of application:
**02.07.2003 Bulletin 2003/27**

(73) Proprietor: **Skyworks Solutions, Inc.**
**Irvine, CA 92612 (US)**

(72) Inventor: **MOLNAR, Alyosha, C.**
**Costa Mesa, CA 92627 (US)**

(74) Representative: **Reeve, Nicholas Edward**
**Reddie & Grose LLP**
**The White Chapel Building**
**10 Whitechapel High Street**
**London E1 8QS (GB)**

(56) References cited:
**US-A- 3 530 365     US-A- 3 559 042**
**US-A- 4 647 843**

**Description**

**BACKGROUND OF THE INVENTION**

**1. Field Of The Invention.**

This invention relates to polyphase filters and, more specifically, to an eight-phase 45° polyphase filter with amplitude matching.

**2. Related Art.**

Certain radio receiver architectures require that signals be phase split equally into eight separate phases with constant 45° phase splits between them. For example, direct conversion receivers and subharmonic frequency translators for use in such receivers may have such requirements. In addition, preprocessors for improving the switching characteristics of a local oscillator input to such frequency translators may also have these requirements.

One of the most common and most reliable ways of achieving phase splits in general is through the use of passive RC filters, that are commonly called polyphase filters. In the simplest RC series circuit, the voltage across the capacitor will lag the current, and the voltage across the resistor, by 90°. In a differential RC phase splitter, the two inputs are 180° out of phase with each other and four outputs are available, each of which has a phase angle difference of 90° relative to the next output.

By selecting the resistor and capacitor values, the phase angle of an output voltage relative to an input voltage can be achieved for a particular frequency. The inputs of two differential RC phase splitters can be connected. The resistor and capacitor values of the two phase splitters can be selected so that there is a 45° phase angle difference between an output of the first phase splitter and a corresponding output of the second phase splitter at a particular frequency. The result is eight outputs with 45° phase splits between them at a particular frequency.

The four outputs that are available from a differential RC phase splitter can be amplitude matched at a particular frequency by selection of appropriate resistor and capacitor values. However, the resistor and capacitor values cannot, in general, be selected to achieve both amplitude matching and a particular phase difference relative to the input.

US 3,530,365 describes a phase shifting network for producing a phase having any value between 0 and 360 degrees.

US 4,647,843 describes a symmetrical polyphase network consisting of a ring of series connected alternate resistors and capacitors, with the junction ports therebetween alternately forming inputs and outputs of the network. This forms a single instance of a four-phase 90 degree phase splitter.

SUMMARY

The invention is defined in the independent claims to which reference should be made. Advantegeous features are set forth in the dependent claims.

BRIEF DESCRIPTION OF THE FIGURES

The invention can be better understood with reference to the following figures. The components in the figures are not necessarily to scale, emphasis instead being placed upon illustrating the principles of the invention.

Figure 1 is a circuit diagram of an RC series circuit with a sinusoidal voltage source.
Figure 2 is a phase or diagram of voltages in Figure 1.
Figure 3 is a circuit diagram of a two-phase 90° polyphase filter.
Figure 4 is a circuit diagram of a four-phase 90° polyphase filter with two inputs.
Figure 5 is a circuit diagram of an eight-phase 45° polyphase filter with two inputs.
Figure 6 is a circuit diagram of an eight-phase 45° polyphase filter with four inputs.
Figure 7 is a block diagram illustrating an example of phase-splitting to achieve an eight-phase 45° phase split with amplitude matching.
Figure 8 is a circuit diagram of an eight-phase 45° polyphase filter with two inputs.
Figure 9a is a graph representing phase angle (between an output and an input) versus frequency.
Figure 9b is a graph representing the difference between the phase angles of two outputs versus frequency.

## DETAILED DESCRIPTION

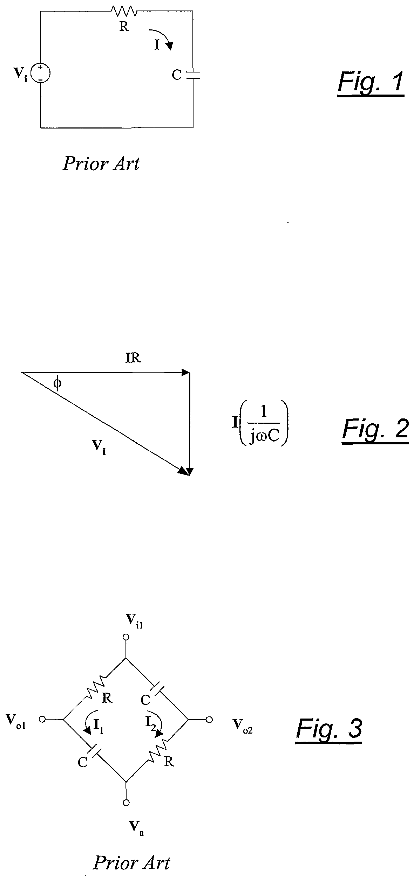

Figure 1 is a circuit diagram, for discussion purposes, of a prior art RC series circuit with a sinusoidal voltage source $V_i$ (holding indicates a phasor) driving a current I through resistor R and capacitor C. Figure 2 is a phasor diagram of voltages in Figure 1. The voltage across resistor R is IR, and the voltage across capacitor C is $I(1/j\omega C)$. $V_i = IR + I(1/j\omega)C)$. The voltage across R, IR, always leads $V_i$ by a phase angle $\phi$, and the voltage across C, $I(1/j\omega)C)$, always lags IR by 90°. The phase angle $\phi = \arctan(1/\omega RC)$. The voltages across R and across C have equal amplitudes when R = $1/\omega C$ or $\omega RC = 1$. When that occurs, $\phi = 45°$, and the voltage across R leads $V_i$ by 45° and the voltage across C lags $V_i$ by 45°.

Figure 3 is a circuit diagram, for discussion purposes, of a two-phase 90° polyphase filter. ("Polyphase filter" and "phase splitter" are used interchangeably.) In Figure 3:

$$\mathbf{V_i} = \mathbf{V_{i1}} - \mathbf{V_a}$$

$$\mathbf{I_1} = \mathbf{I_2} = \frac{\mathbf{V_i}}{R + \frac{1}{j\omega C}}$$

$$\mathbf{V_1} = \mathbf{V_{o1}} - \mathbf{V_a} = \mathbf{I_1}\left(\tfrac{1}{j\omega C}\right) = \frac{\mathbf{V_i}}{R + \frac{1}{j\omega C}}\left(\tfrac{1}{j\omega C}\right) = \mathbf{V_i}\frac{1}{1 + j\omega RC}$$

$$\mathbf{V_2} = \mathbf{V_{o2}} - \mathbf{V_a} = \mathbf{I_2}R = \frac{\mathbf{V_i}}{R + \frac{1}{j\omega C}}R = \mathbf{V_i}\frac{j\omega RC}{1 + j\omega RC} = \mathbf{V_1}\left(j\omega RC\right)$$

$V_1$ and $V_2$ are 90° out of phase with respect to each other, regardless of the frequency, the value of R, or the value of C. However, the amplitudes of $V_1$ and $V_2$ are equal only when $\omega RC = 1$, i.e., when $\omega = 1/RC$. When that occurs, the phase angles of $V_1$ and $V_2$ with respect to $V_i$ are -45° and +45°, respectively. Each side of Figure 3 is effectively an RC series circuit as in Figure 1.

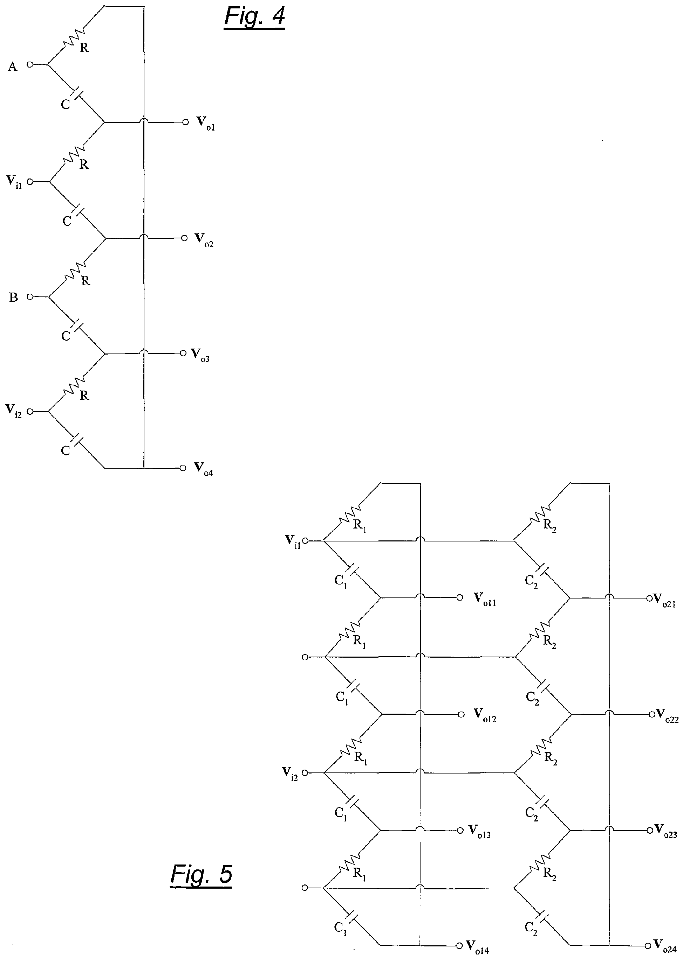

Figure 4 is a circuit diagram of a differential four-phase 90° polyphase filter. Inputs $V_{i1}$ and $V_{i2}$ are of equal amplitude and 180° out of phase with each other. As $V_{i1} = -V_{i2}$, as each of the resistors has the same value, and as each of the capacitors has the same value, the symmetry renders points A and B virtual grounds. The circuit of Figure 4 is a combination of two circuits like the circuit of Figure 3. Consequently, $V_{o1}$ lags $V_{o2}$ by 90°, and they straddle $V_{i1}$ with respect to phase angle. Similarly, $V_{o3}$ lags $V_{o4}$ by 90°, and they straddle $V_{i2}$ with respect to phase angle. Due to the symmetry again, $V_{o1}$ and $V_{o2}$ are 180° out of phase with $V_{o3}$ and $V_{o4}$, respectively. Therefore, the phase angle of each of the four outputs is 90° different than the next output. As discussed above, amplitude matching occurs only when $\omega = 1/RC$. When that occurs, $V_{o1}$, $V_{o2}$, $V_{o3}$ and $V_{o4}$ have phase angles of -45°, 45°, 135° and 225°, respectively, with respect to $V_{i1}$.

Figure 5 is a circuit diagram of a differential eight-phase 45° polyphase filter. It is a combination of two circuits like the circuit of Figure 4, with the respective inputs of the two circuits connected and the respective virtual grounds of the two circuits connected. Inputs $V_{i1}$ and $V_{i2}$ are of equal amplitude and 180° out of phase with each other. Each of outputs $V_{o11}$, $V_{o12}$, $V_{o13}$ and $V_{o14}$ is 90° out of phase with the next output and, similarly, each of outputs $V_{o21}$, $V_{o22}$, $V_{o23}$ and $V_{o24}$ is 90° out of phase with the next output.

As illustrated in Figure 2, the phase angle of an output voltage relative to an input voltage can be achieved for a particular frequency, by selection of the resistor and capacitor values. In the circuit of Figure 5, the values of $R_1C_1$ and $R_2C_2$ can be chosen so that $V_{o21}$, $V_{o22}$, $V_{o23}$ and $V_{o24}$ lead $V_{o11}$, $V_{o12}$, $V_{o13}$ and $V_{o14}$, respectively, by 45° for a particular frequency (for an unloaded filter). For example, $V_{o11}$ leads $V_{i1}$ by 22.5° when $1/\omega R_1,C_1 = \tan 22.5° = 0.41421$, and $V_{o21}$ leads $V_{i1}$ by 67.5° when $1/\omega)R_2C_2 = \tan 67.5° = 2.41421$ (for an unloaded filter). In that case, the phase angles of $V_{o11}$, $V_{o21}$, $V_{o12}$, $V_{o22}$, $V_{o13}$, $V_{o23}$, $V_{o14}$ and $V_{o24}$ are 22.5°, 67.5°, 112.5°, 157.5°, 202.5°, 247.5°, 292.5° and 337.5°, respectively, with respect to $V_{i1}$ for an unloaded filter. In that case:

$$\frac{R_1 C_1}{R_2 C_2} = \frac{\frac{1}{\omega R_2 C_2}}{\frac{1}{\omega R1C1}} = \frac{2.41421}{0.41421} \cong 5.7$$

$$\left(\frac{1}{\omega R_1 C_1}\right)\left(\frac{1}{\omega R_2 C_2}\right) = (2.41421)(0.41421) = 1$$ (which necessarily follows because 22.5° and 67.5° are complementary angles, and their tangents are reciprocals);

$$\frac{1}{\omega^2 R_1 C_1 R_2 C_2} = 1$$

and

$$R_1 C_1 R_2 C_2 = \frac{1}{\omega^2}$$

This example results in eight outputs with 45° phase splits between them at a particular frequency. However, the two relationships: $\frac{R_1 C_1}{R_2 C_2} \cong 5.7$ 5.7 and $R_1 C_1 R_2 C_2 = \frac{1}{\omega^2}$, require that $\frac{1}{R_1 C_1} < \omega < \frac{1}{R_2 C_2}$. That is, with this example neither part of the circuit in Figure 5 can be at its amplitude matched point. Because inputs $V_{i1}$ and $V_{i2}$ are of equal amplitude and 180° out of phase with each other, amplitude matched outputs could have been achieved if

$\omega = \frac{1}{RC}$, but then the desired 45° phase splits between the outputs would not occur.

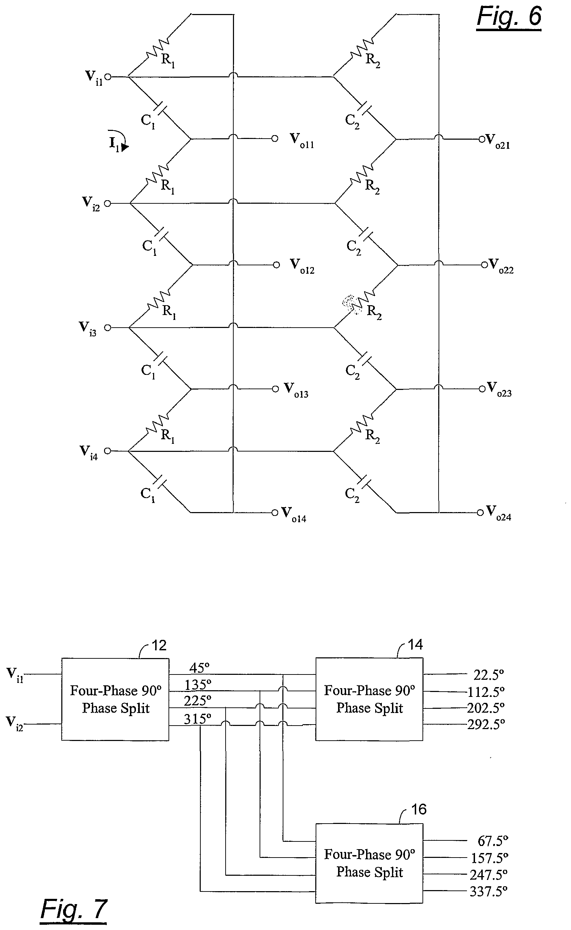

Figure 6 is a circuit diagram similar to Figure 5, but there are four inputs $V_{i1,}$ $V_{i2},$ $V_{i3}$ and $V_{i4}.$ The intermediate points which were virtual grounds in Figure 5 are additional voltage inputs in Figure 6. In the circuit of Figure 6, for an unloaded filter

$$\mathbf{V}_{o11} - \mathbf{V}_{i2} = \mathbf{I}_1 R_1 = \frac{(\mathbf{V}_{i1} - \mathbf{V}_{i2})R_1}{R_1 + \frac{1}{j\omega C_1}} = (\mathbf{V}_{i1} - \mathbf{V}_{i2})\frac{j\omega R_1 C_1}{1 + j\omega R_1 C_1}$$

$$\mathbf{V}_{o11} = \mathbf{V}_{i1}\frac{j\omega R_1 C_1}{1 + j\omega R_1 C_1} + \mathbf{V}_{i2}\left(1 - \frac{j\omega R_1 C_1}{1 + j\omega R_1 C_1}\right)$$

$$= \mathbf{V}_{i1}\frac{j\omega R_1 C_1}{1 + j\omega R_1 C_1} + \mathbf{V}_{i2}\frac{1}{1 + j\omega R_1 C_1}$$

Similarly, the other seven outputs in Figure 6 can be expressed in terms of the inputs as follows:

$$\mathbf{V}_{o12} = \mathbf{V}_{i2}\frac{j\omega R_1 C_1}{1 + j\omega R_1 C_1} + \mathbf{V}_{i3}\frac{1}{1 + j\omega R_1 C_1}$$

$$V_{o13} = V_{i3} \frac{j\omega R_1 C_1}{1 + j\omega R_1 C_1} + V_{i4} \frac{1}{1 + j\omega R_1 C_1}$$

$$V_{014} = V_{i4} \frac{j\omega R_1 C_1}{1 + j\omega R_1 C_1} + V_{i1} \frac{1}{1 + j\omega R_1 C_1}$$

$$V_{021} = V_{i1} \frac{j\omega R_2 C_2}{1 + j\omega R_2 C_2} + V_{i2} \frac{1}{1 + j\omega R_2 C_2}$$

$$V_{o22} = V_{i2} \frac{j\omega R_2 C_2}{1 + j\omega R_2 C_2} + V_{i3} \frac{1}{1 + j\omega R_2 C_2}$$

$$V_{023} = V_{i3} \frac{j\omega R_2 C_2}{1 + j\omega R_2 C_2} + V_{i4} \frac{1}{1 + j\omega R_2 C_2}$$

$$V_{o24} = V_{i4} \frac{j\omega R_2 C_2}{1 + j\omega R_2 C_2} + V_{i1} \frac{1}{1 + j\omega R_2 C_2}$$

Each output has a contribution from two inputs. The transfer functions applied to the two inputs have the same denominator, and the numerator of one transfer function is entirely "real" and the numerator of the other transfer function is entirely "imaginary."

If $V_{i2}$ leads $V_{i1}$ by 90°, then each of those inputs will add in-phase for $V_{o11}$ and each of those inputs will add in-phase for $V_{o21}$. Similarly, if each input leads the preceding input by 90°, then the two inputs to each output will add in-phase.

Continuing with the circuit of Figure 6, if, in addition to leading the preceding input by 90°, each of the inputs $V_{i1}$, $V_{i2}$, $V_{i3}$ and $V_{i4}$ has the same amplitude, then

$$V_{i2} = jV_{i1},$$

$$V_{i3} = jV_{i2} = -V_{i1},$$

and

$$V_{i4} = jV_{i3} = -jV_{i1}.$$

In that case,

$$V_{o11} = jV_{i1} \frac{1 + \omega R_1 C_1}{1 + j\omega R_1 C_1}$$

$$V_{o12} = -V_{i1} \frac{1 + \omega R_1 C_1}{1 + j\omega R_1 C_1}$$

$$V_{013} = -j\dot{V}_{i1}\frac{1+\omega R_1 C_1}{1+j\omega R_1 C_1}$$

$$V_{014} = V_{i1}\frac{1+\omega R_1 C_1}{1+j\omega R_1 C_1}$$

$$V_{o21} = jV_{i1}\frac{1+\omega R_2 C_2}{1+j\omega R_2 C_2}$$

$$V_{o22} = -V_{i1}\frac{1+\omega R_2 C_2}{1+j\omega R_2 C_2}$$

$$V_{023} = -jV_{i1}\frac{1+\omega R_2 C_2}{1+j\omega R_2 C_2}$$

$$V_{024} = V_{i1}\frac{1+\omega R_2 C_2}{1+j\omega R_2 C_2}$$

Each of outputs $V_{o11}$, $V_{o12}$, $V_{o13}$ and $V_{o14}$ will have the same amplitude, and each of outputs $V_{o21}$, $V_{o22}$, $V_{o23}$ and $V_{o24}$ will have the same amplitude. The ratio of $V_{o11}$ to $V_{o21}$ is

$$\frac{(1+\omega R_1 C_1)(1+j\omega R_2 C_2)}{(1+j\omega R_1 C_1)(1+\omega R_2 C_2)} = \frac{(1+\omega R_1 C_1)+j(\omega^2 R_1 C_1 R_2 C_2 + \omega R_2 C_2)}{(1+\omega R_2 C_2)+j(\omega^2 R_1 C_1 R_2 C_2 + \omega R_1 C_1)}$$

If $R_1 C_1 R_2 C_2 = 1/\omega^2$, then the ratio of $V_{o11}$ to $V_{o21}$ is

$$\frac{(1+\omega R_1 C_1)+j(1+\omega R_2 C_2)}{(1+\omega R_2 C_2)+j(1+\omega R_1 C_1)}$$

The absolute value of both numerator and the denominator is the same, $V_{o11}$ and $V_{o21}$ have the same amplitude, and all eight of the outputs will have the same amplitude.

Therefore, for an unloaded filter, the eight outputs in the circuit of Figure 6 will be amplitude matched, each of outputs $V_{o11}$, $V_{o12}$, $V_{o13}$ and $V_{o14}$ will lead the previous output by 90°, and each of outputs $V_{o21}$, $V_{o22}$, $V_{o23}$ and $V_{o24}$ will lead the previous output by 90°, if $R_1 C_1 R_2 C_2 = \dfrac{1}{\omega^2}$ and each of the inputs $V_{i1}$, $V_{i2}$, $V_{i3}$ and $V_{i4}$ has the same amplitude and leads the preceding input by 90°. In addition, if $\dfrac{R_1 C_1}{R_2 C_2} \cong 5.7$, then the phase angles of $V_{o11}$, $V_{o21}$, $V_{o12}$, $V_{o22}$, $V_{o13}$, $V_{o23}$, $V_{o14}$ and $V_{o24}$ will be 22.5°, 67.5°, 112.5°, 157.5°, 202.5°, 247.5°, 292.5° and 337.5°, respectively, with respect to $(V_{i1} - V_{i2})$. This would be the eight-phase 45° phase splitting with amplitude matching which is sought. Since $(V_{i1} - V_{i2}) = (1 - j)V_{i1}$, $(V_{i1} - V_{i2})$ lags $V_{i1}$ by 45°.

Figure 7 is a block diagram illustrating an example of phase-splitting to achieve an eight-phase 45° phase split with amplitude matching. Two signals $V_{i1}$ and $V_{i2}$, of equal amplitude and 180° out of phase with each other, can be split (12) to four intermediate signals of equal amplitude, each one of which is 90° out of phase with the next one of the four signals. The second input, $V_{i2}$, can already be available in some embodiments and, in other embodiments, can readily be obtained by inverting $V_{i1}$ as is well known in the art. In one embodiment, the amplitude matching of the resulting four intermediate signals can be achieved for a particular frequency by appropriate selection of component values in a four-phase 90° polyphase filter. The amplitude-matched point can result in the four intermediate signals having phase angles of 45°, 135°, 225°, and 315° with respect to $V_{i1}$ in Figure 7. This was explained regarding the circuit illustrated in Figure 4.

The four intermediate signals can be converted (14) to a first group of four output signals, each one of which is 90° out of phase with the next one. The four intermediate signals also can be converted (16) to a second group of four output signals, each one of which is 90° out of phase with the next one. The first and second groups of output signals in Figure 7 can be offset from each other, respectively, by 45°. This was explained regarding the circuit illustrated in Figure 5. For an unloaded filter, in one embodiment, this can be achieved for a particular frequency by appropriate selection of component values in two four-phase 90° polyphase filters with the same input signals. This can result in the eight output signals having phase angles of 22.5°, 67.5°, 112.5°, 157.5°, 202.5°, 247.5°, 292.5°, and 337.5° with respect to $V_{i1}$. Amplitude matching of the eight output signals in Figure 7 can be achieved because of the amplitude matching of the four intermediate signals. This was explained regarding the circuit illustrated in Figure 6.

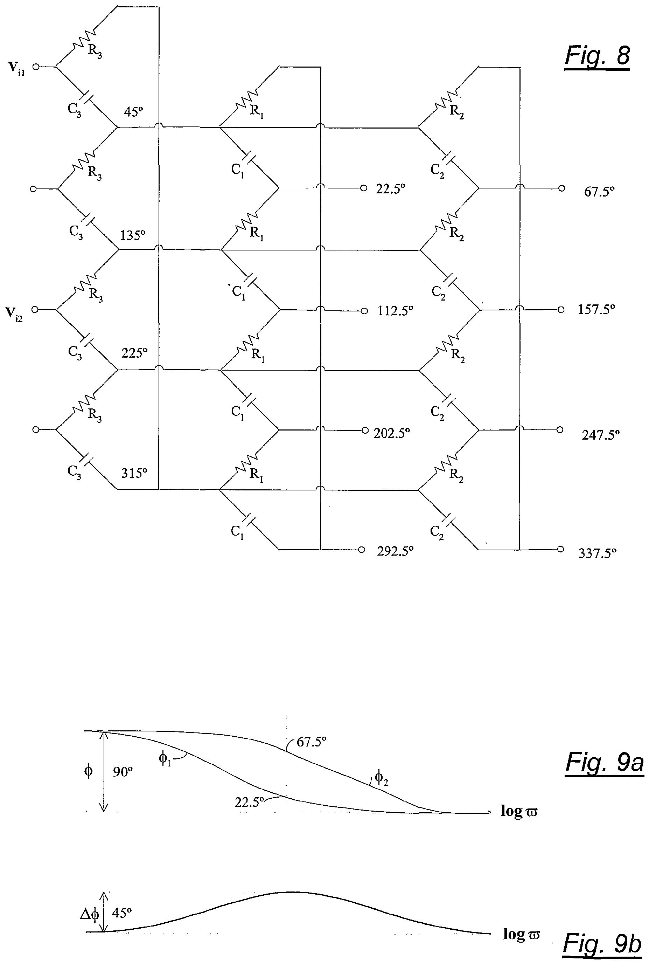

Figure 8 is a circuit diagram of a differential eight-phase 45° polyphase filter, implementing the block diagram of Figure 7. Inputs $V_{i1}$ and $V_{i2}$ are of equal amplitude and 180° out of phase with each other. The first stage is similar to the circuit of Figure 4. When $\omega = \dfrac{1}{R_3 C_3}$, the four outputs of the first stage (i.e., the intermediate signals which are inputs to the second stage) will be 90° phase-split and amplitude matched. These are the input conditions discussed above for one example of the circuit of Figure 6. The first stage outputs (second stage inputs) will have phase angles of 45°, 135°, 225° and 315° with respect to $V_{i1}$.

The second stage of the circuit of Figure 8 is similar to the circuit of Figure 6. For an unloaded filter, when

$$\omega = \frac{1}{R_3 C_3}, \quad R_1 C_1 R_2 C_2 = \frac{1}{\omega^2}, \quad \text{and} \quad \frac{R_1 C_1}{R_2 C_2} \cong 5.7,$$ the second stage outputs will be 45° phase-split and amplitude matched. They will have phase angles of 22.5°, 67.5°, 112.5°, 157.5°, 202.5°, 247.5°, 292.5° and 337.5° with respect to $V_{i1}$.

Figure 9a is an illustration representing a plot of phase angle $\phi$ (between an output and an input in the circuit of Figure 8) versus log $\omega$. As illustrated in Figure 2, a phase angle $\phi = \arctan(1/\omega RC)$. The phase angle $\phi$ approaches 90° asymptotically as $1/\omega RC$ increases and is effectively a constant 90° when $\omega$ is less than about an order of magnitude less than $1/RC$. The phase angle $\phi$ approaches 0° asymptotically as $1/\omega)RC$ decreases and is effectively a constant 0° when $\omega$ is more than about an order of magnitude more than $1/RC$. The change in $\phi$ for a given change in $\omega$ is greatest when $\omega = 1/RC$, and $\phi = 45°$. It is also relatively constant around $\phi = 45°$, and then diminishes toward zero as $\Phi$ approaches 0° or 90°.

Figure 9a is an illustration of two plots, $\phi_1$ and $\phi_2$, representing the phase angle for two different values of RC, $R_1 C_1$ and $R_2 C_2$, respectively. If $R_1 C_1 = (K)(R_2 C_2)$ where K is a constant, then $\phi_1$ for $\omega = \omega_a$ has the same value as $\phi_2$ for $\omega = (1/K)\omega_a$, since $\phi = \arctan(1/\omega RC)$. Since $\log((1/K)\omega) = \log \omega + \log (1/K)$, and since $\log (1/K)$ is a constant, the plot representing $\phi_1$ is just a translation along the log $\omega$ axis of the plot representing $\phi_2$.

Figure 9b is an illustration representing a plot of the difference in phase angle $\Delta\phi$ between $\phi_2$ and $\phi_1$ in Figure 9a versus log $\omega$. If $\dfrac{R_1 C_1}{R_2 C_2} \cong 5.7$, then $\phi_1$ will be 22.5° when $\phi_2$ is 67.5°. This was explained regarding the circuit illustrated in Figure 5. In that case, $\Delta\phi$ would peak at that point and would equal 45°. As $\omega$ changes in either direction from that point, one of the two phase angles ($\phi_1$ or $\phi_2$) will move closer to 45° and the other will move further away. For a given change in $\omega$, the phase angle getting closer to 45° will increase (or decrease) more than the other phase angle, and $\Delta\phi$ will decrease as represented in Figure 9b.

For the 22.5°/67.5° phase-split at the operating frequency, $\Delta\phi$ remains relatively flat over a wide band (approximately the desired operating frequency $\pm50\%$). However, a circuit such as in Figure 5 would have a severe amplitude mismatch at its output as a consequence of the offset nature of the two RC constants. The addition of the first stage, as in the example of Figure 8 permits the eight-phase 45° split with amplitude matching. The first stage distributes power evenly among the four inputs to the second stage, cancelling out the uneven distribution which would occur otherwise in the second stage.

The circuits discussed above were analyzed in a voltage mode, but the same principles apply to current mode signals. Using current inputs and outputs would result in the same phase splitting and amplitude matching.

**Claims**

1. A polyphase filter comprising:

   a first four-phase 90 degree phase splitter (12) with four outputs and two inputs for receiving input signals of equal magnitude and opposite phases;
   a second four-phase 90 degree phase splitter (14) with four inputs coupled respectively to the four outputs of the first phase splitter;
   a third four-phase 90 degree phase splitter (16) with four inputs coupled respectively to the four outputs of the first phase splitter;
   each of the first (12), second (14) and third (16) 90 degree phase splitters including a four resistors and four capacitors, wherein each one of the fours resistors follows one of the four capacitors respectively in a series loop, the resistor and capacitor values of the second and third phase splitters being selected to obtain a 45 degree phase angle difference between corresponding outputs of the second and third phase splitters to provide a full eight-phase 45 degree split, and the resistor and capacitor values of the first phase splitter being selected to achieve equal amplitudes of the four outputs of the first phase splitter, and the resistor and capacitor values of the second phase splitter being selected to achieve equal amplitudes at the outputs of the second phase splitters, and the resistor and capacitor values of the third phase splitter being selected to achieve equal amplitudes at the outputs of the third phase splitter.

2. The polyphase filter of claim 1, wherein the first phase splitter (12) includes:

   four first resistors of a substantially equal resistance value;
   four first capacitors of a substantially equal capacitance value; and
   each one of the four first resistors follows one of the first four capacitors, respectively in a series loop.

3. The polyphase filter of claim 2, wherein a product of the resistance value times the capacitance value is substantially equal to a ratio of one divided by a selected operating frequency when the operating frequency is expressed in radians.

4. The polyphase filter of claim 1 or 2, wherein the second phase splitter (14) includes:

   four second resistors of a substantially equal resistance value; and four second capacitors of a substantially equal capacitance value; each one of the four second resistors following one of the second four capacitors, respectively, in a series loop; and
   the third phase splitter (16) includes: four third resistors of a substantially equal resistance value; and four third capacitors of a substantially equal capacitance value; each one of the four third resistors following one of the third four capacitors, respectively, in a series loop.

5. The polyphase filter of claim 4, wherein a product of tan 22.5 degrees times the resistance value of the second resistors times the capacitance value of the second capacitors is substantially equal to a ratio of one divided by a selected operating frequency, when the operating frequency is expressed in radians; and a product of tan 67.5 degrees times the resistance value of the third resistors times the capacitance value of the third capacitors is substantially equal to a ratio of one divided by the selected operating frequency, when the operating frequency is expressed in radians.

6. The polyphase filter of claim 4, wherein:

   the resistance value of the second resistors times the capacitance value of the second capacitors defines a second product;
   the resistance value of the third resistors times the capacitance value of the third capacitors defines a third product;
   a ratio of the second product divided by the third product is substantially equal to a ratio of tan 67.5 degrees divided by tan 22.5 degrees; and
   a product of the second product times the third product is substantially equal to a ratio of one divided by a square of a selected operating frequency, when the operating frequency is expressed in radians.

7. A method of signal phase-splitting, the method comprising the steps of:

splitting two signals into four intermediate signals using a first phase splitter, the two signals being of substantially equal amplitude and substantially 180 degrees out of phase with each other, and each of the four intermediate signals being of a substantially equal amplitude and substantially 90 degrees out of phase with each other; and converting the four intermediate signals into a first group of four output signals with a second phase splitter, the four output signals being of a substantially equal amplitude and being substantially 90 degrees out of phase with the other output signals in the first group;
converting the four intermediate signals to a second group of four output signals with a third phase splitter the four output signals being of a substantially equal amplitude and being substantially 90 degrees out of phase with the other output signals in the second group;
each of the output signals of the first group being substantially 45 degrees out of phase with a respective output signal in the second group, wherein each of the first, second and third phase splitters comprises four resistors and four capacitors in a series loop, each one of the four resistors being followed in the series loop by one of the four capacitors, respectively.

8. The method of claim 7 further comprising providing a second one of the two signals by inverting a first one of the two signals.

9. The method of any of claims 7 or 8, wherein the splitting step includes:
inputting the two signals to a first four-phase 90 degree phase splitter, where the first phase splitter comprises four first resistors and four first capacitors in a series loop, each one of the four first resistors being followed in the series loop by one of the four first capacitors, respectively, the four first resistors being of a substantially equal resistance value, and the four first capacitors being of a substantially equal capacitance value.

10. The method of claim 9, wherein a product of the resistance value times the capacitance value is substantially equal to a ratio of one divided by a selected operating frequency when the operating frequency is expressed in radians.

11. The method of any of claims 7 to 10, wherein the converting step further comprises:

inputting the four intermediate signals to a second four-phase 90 degree phase splitter; and inputting the four intermediate signals to a third four-phase 90 degree phase splitter.

12. The method of claim 11, wherein the second phase splitter comprises four second resistors and four second capacitors in a series loop, each one of the four second resistors being followed in the series loop by one of the four second capacitors, respectively, the four second resistors being of a substantially equal resistance value, and the four second capacitors being of a substantially equal capacitance value; and where the third phase splitter comprises four third resistors and four third capacitors in a series loop, each one of the four third resistors being followed in the series loop by one of the four third capacitors, respectively, the four third resistors being of a substantially equal resistance value, and the four third capacitors being of a substantially equal capacitance value.

13. The method of claim 12, where a product of tan 22.5 degrees times the resistance value of the second resistors times the capacitance value of the second capacitors is substantially equal to a ratio of one divided by a selected operating frequency when the operating frequency is expressed in radians; and a product of tan 67.5 degrees times the resistance value of the third resistors times the capacitance value of the third capacitors is substantially equal to a ratio of one divided by the selected operating frequency when the operating frequency is expressed in radians.

14. The method of claim 12, wherein a second product of the resistance value of the second resistors times the capacitance value of the second capacitors, and a third product, of the resistance value of the third resistors times the capacitance value of the third capacitors, result in: a ratio of the second product divided by the third product being substantially equal to a ratio of tan 67.5 degrees divided by tan 22.5 degrees; and a product of the second product times the third product being substantially equal to one divided by a square of a selected operating frequency, when the operating frequency is expressed in radians.

**Patentansprüche**

1.  Mehrphasenfilter, umfassend:

    einen ersten vierphasigen 90-Grad-Phasenteiler (12) mit vier Ausgängen und zwei Eingängen zum Empfangen von Eingangssignalen gleicher Größe und entgegengesetzter Phasen;
    einen zweiten vierphasigen 90-Grad-Phasenteiler (14) mit vier Eingängen, die jeweils an die vier Ausgänge des ersten Phasenteilers gekoppelt sind;
    einen dritten vierphasigen 90-Grad-Phasenteiler (16) mit vier Eingängen, die jeweils an die vier Ausgänge des ersten Phasenteilers gekoppelt sind;
    wobei jeder der ersten (12), zweiten (14) und dritten (16) 90-Grad-Phasenteiler vier Widerstände und vier Kondensatoren beinhaltet, wobei jeder der vier Widerstände einem der vier Kondensatoren jeweils in einer Reihenschaltung nachgeschaltet ist, wobei die Widerstands- und Kondensatorwerte der zweiten und dritten Phasenteiler ausgewählt sind, um eine 45-Grad-Phasenwinkeldifferenz zwischen entsprechenden Ausgängen der zweiten und dritten Phasenteiler zu erhalten, um eine vollständige acht-phasige 45-Grad-Aufteilung bereitzustellen, und die Widerstands- und Kondensatorwerte des ersten Phasenteilers ausgewählt sind, um gleiche Amplituden der vier Ausgänge des ersten Phasenteilers zu erreichen, und wobei die Widerstands- und Kondensatorwerte des zweiten Phasenteilers ausgewählt sind, um gleiche Amplituden an den Ausgängen der zweiten Phasenteiler zu erreichen, und wobei die Widerstands- und Kondensatorwerte des dritten Phasenteilers ausgewählt sind, um gleiche Amplituden an den Ausgängen des dritten Phasenteilers zu erreichen.

2.  Mehrphasenfilter nach Anspruch 1, wobei der erste Phasenteiler (12) folgendes umfasst:

    vier erste Widerstände mit einem im Wesentlichen gleichen Widerstandswert;
    vier erste Kondensatoren mit einem im Wesentlichen gleichen Kapazitätswert; und
    wobei jeder der vier ersten Widerstände einem der ersten vier Kondensatoren, jeweils in einer Reihenschaltung nachgeschaltet ist.

3.  Mehrphasenfilter nach Anspruch 2, wobei ein Produkt aus dem Widerstandswert mal dem Kapazitätswert im Wesentlichen gleich zu einem Verhältnis von eins dividiert durch eine ausgewählte Betriebsfrequenz ist, wenn die Betriebsfrequenz in Bogenmaß ausgedrückt wird.

4.  Mehrphasenfilter nach Anspruch 1 oder 2, wobei der zweite Phasenteiler (14) folgendes beinhaltet:

    vier zweite Widerstände mit einem im Wesentlichen gleichen Widerstandswert; und vier zweite Kondensatoren mit einem im Wesentlichen gleichen Kapazitätswert; wobei jeder der vier zweiten Widerstände jeweils einem der zweiten vier Kondensatoren in einer Reihenschaltung nachgeschaltet ist; und
    der dritte Phasenteiler (16) folgendes beinhaltet: vier dritte Widerstände mit einem im Wesentlichen gleichen Widerstandswert; und vier dritte Kondensatoren mit einem im Wesentlichen gleichen Kapazitätswert; wobei jeder der vier dritten Widerstände jeweils einem der dritten vier Kondensatoren in einer Reihenschaltung nachgeschaltet ist.

5.  Mehrphasenfilter nach Anspruch 4, wobei ein Produkt aus tan 22,5 Grad mal dem Widerstandswert der zweiten Widerstände mal dem Kapazitätswert der zweiten Kondensatoren im Wesentlichen gleich zu einem Verhältnis von eins dividiert durch eine ausgewählte Betriebsfrequenz ist, wenn die Betriebsfrequenz in Bogenmaß ausgedrückt wird; und ein Produkt aus tan 67,5 Grad mal dem Widerstandswert der dritten Widerstände mal dem Kapazitätswert der dritten Kondensatoren im Wesentlichen gleich einem Verhältnis von eins dividiert durch die ausgewählte Betriebsfrequenz ist, wenn die Betriebsfrequenz in Bogenmaß ausgedrückt wird.

6.  Mehrphasenfilter nach Anspruch 4, wobei:

    der Widerstandswert der zweiten Widerstände mal dem Kapazitätswert der zweiten Kondensatoren ein zweites Produkt definiert;
    der Widerstandswert der dritten Widerstände mal dem Kapazitätswert der dritten Kondensatoren ein drittes Produkt definiert;
    ein Verhältnis des zweiten Produkts dividiert durch das dritte Produkt im Wesentlichen gleich zu einem Verhältnis von tan 67,5 Grad dividiert durch tan 22,5 Grad ist; und
    ein Produkt des zweiten Produkts mal dem dritten Produkt im Wesentlichen gleich zu einem Verhältnis von eins dividiert durch ein Quadrat einer ausgewählten Betriebsfrequenz ist, wenn die Betriebsfrequenz in Bogenmaß ausgedrückt wird.

7. Verfahren zum Signalphasenteilen, wobei das Verfahren die folgenden Schritte umfasst:

Aufteilen zweier Signale in vier Zwischensignale unter Verwendung eines ersten Phasenteilers, wobei die zwei Signale, die eine im Wesentlichen gleiche Amplitude aufweisen und im Wesentlichen 180 Grad phasenverschoben zueinander sind, und jedes der vier Zwischensignale eine im Wesentlichen gleiche Amplitude aufweist und im Wesentlichen 90 Grad phasenverschoben zueinander sind; und
Umwandeln der vier Zwischensignale in eine erste Gruppe von vier Ausgangssignalen mit einem zweiten Phasenteiler, wobei die vier Ausgangssignale eine im Wesentlichen gleiche Amplitude aufweisen und im Wesentlichen 90 Grad phasenverschoben zu den anderen Ausgangssignalen in der ersten Gruppe sind;
Umwandeln der vier Zwischensignale in eine zweite Gruppe von vier Ausgangssignalen mit einem dritten Phasenteiler, wobei die vier Ausgangssignale eine im Wesentlichen gleiche Amplitude aufweisen und im Wesentlichen 90 Grad phasenverschoben zu den anderen Ausgangssignalen in der zweiten Gruppe sind;
wobei jedes der Ausgangssignale der ersten Gruppe im Wesentlichen 45 Grad phasenverschoben zu dem entsprechenden Ausgangssignal in der zweiten Gruppe ist, wobei jeder der ersten, zweiten und dritten Phasenteiler vier Widerstände und vier Kondensatoren in einer Reihenschaltung umfasst, wobei jedem der vier Widerstände in der Reihenschaltung jeweils einer der vier Kondensatoren nachgeschaltet ist.

8. Verfahren nach Anspruch 7, ferner umfassend das Bereitstellen eines zweiten der zwei Signale durch Umkehren eines ersten der zwei Signale.

9. Verfahren nach einem der Ansprüche 7 oder 8, wobei der Aufteilungsschritt folgendes beinhaltet:
Eingeben der beiden Signale in einen ersten vierphasigen 90-Grad-Phasenteiler, wobei der erste Phasenteiler vier erste Widerstände und vier erste Kondensatoren in einer Reihenschaltung umfasst, wobei jedem der vier ersten Widerstände in der Reihenschaltung jeweils einer der vier ersten Kondensatoren nachgeschaltet ist, wobei die vier ersten Widerstände einen im Wesentlichen gleichen Widerstandswert aufweisen und die vier ersten Kondensatoren einen im Wesentlichen gleichen Kapazitätswert aufweisen.

10. Verfahren nach Anspruch 9, wobei ein Produkt aus dem Widerstandswert mal dem Kapazitätswert im Wesentlichen gleich zu einem Verhältnis von eins dividiert durch eine ausgewählte Betriebsfrequenz ist, wenn die Betriebsfrequenz in Bogenmaß ausgedrückt wird.

11. Verfahren nach einem der Ansprüche 7 bis 10, wobei der Umwandlungsschritt ferner umfasst:

Eingeben der vier Zwischensignale in einen zweiten vierphasigen 90-Grad-Phasenteiler; und
Eingeben der vier Zwischensignale in einen dritten vierphasigen 90-Grad-Phasenteiler.

12. Verfahren nach Anspruch 11, wobei der zweite Phasenteiler vier zweite Widerstände und vier zweite Kondensatoren in einer Reihenschaltung umfasst, wobei jedem der vier zweiten Widerstände in der Reihenschaltung jeweils einer der vier zweiten Kondensatoren nachgeschaltet ist, wobei die vier zweiten Widerstände einen im Wesentlichen gleichen Widerstandswert aufweisen und die vier zweiten Kondensatoren einen im Wesentlichen gleichen Kapazitätswert aufweisen; und wobei der dritte Phasenteiler vier dritte Widerstände und vier dritte Kondensatoren in einer Reihenschaltung umfasst, wobei jeder der vier dritten Widerstände in der Reihenschaltung von jeweils einem der vier dritten Kondensatoren nachgeschaltet ist, wobei die vier dritten Widerstände einen im Wesentlichen gleichen Widerstandswert aufweisen und die vier dritten Kondensatoren einen im Wesentlichen gleichen Kapazitätswert aufweisen.

13. Verfahren nach Anspruch 12, wobei ein Produkt aus tan 22,5 Grad mal dem Widerstandswert der zweiten Widerstände mal dem Kapazitätswert der zweiten Kondensatoren im Wesentlichen gleich zu einem Verhältnis von eins dividiert durch eine ausgewählte Betriebsfrequenz ist, wenn die Betriebsfrequenz in Bogenmaß ausgedrückt wird; und ein Produkt aus tan 67,5 Grad mal dem Widerstandswert der dritten Widerstände mal dem Kapazitätswert der dritten Kondensatoren im Wesentlichen gleich zu einem Verhältnis von eins dividiert durch die ausgewählte Betriebsfrequenz ist, wenn die Betriebsfrequenz in Bogenmaß ausgedrückt wird.

14. Verfahren nach Anspruch 12, wobei ein zweites Produkt aus dem Widerstandswert der zweiten Widerstände mal dem Kapazitätswert der zweiten Kondensatoren und ein drittes Produkt aus dem Widerstandswert der dritten Widerstände mal dem Kapazitätswert der dritten Kondensatoren, dazu führen, dass: ein Verhältnis des zweiten Produkts dividiert durch das dritte Produkt im Wesentlichen gleich zu einem Verhältnis von tan 67,5 Grad dividiert durch tan 22,5 Grad ist; und ein Produkt aus dem zweiten Produkt mal dem dritten Produkt im Wesentlichen gleich eins dividiert durch ein Quadrat einer ausgewählten Betriebsfrequenz ist, wenn die Betriebsfrequenz in Bogenmaß angegeben wird.

**Revendications**

1. Filtre polyphasé comprenant :

   un premier déphaseur quatre phases 90 degrés (12) muni de quatre sorties et de deux entrées permettant la réception de signaux d'entrée de magnitude égale et de phases opposées ;
   un deuxième déphaseur quatre phases 90 degrés (14) muni de quatre entrées connectées respectivement aux quatre sorties du premier déphaseur ;
   un troisième déphaseur quatre phases 90 degrés (16) muni de quatre entrées connectées respectivement aux quatre sorties du premier déphaseur ;
   chacun des premier (12), deuxième (14) et troisième (16) déphaseurs quatre phases 90 degrés comprenant quatre résistances et quatre condensateurs, chacune des quatre résistances suivant un des quatre condensateurs respectivement dans une boucle en série, les valeurs de résistance et de condensateur des deuxième et troisième déphaseurs étant choisies afin d'obtenir une différence d'angle de phase de 45 degrés entre les sorties correspondantes des deuxième et troisième déphaseurs pour fournir un déphasage huit phases 45 degrés complet, et les valeurs de résistance et de condensateur du premier déphaseur étant choisies pour obtenir des amplitudes égales des quatre sorties du premier déphaseur, et les valeurs de résistance et de condensateur du deuxième déphaseur étant choisies pour obtenir des amplitudes égales aux sorties du deuxième déphaseur, et les valeurs de résistance et de condensateur du troisième déphaseur étant choisies pour obtenir des amplitudes égales aux sorties du troisième déphaseur.

2. Filtre polyphasé selon la revendication 1, dans lequel le premier déphaseur (12) comprend :

   quatre premières résistances d'une valeur de résistance sensiblement égale ;
   quatre premiers condensateurs d'une valeur de capacitance sensiblement égale ; et
   chacune des quatre premières résistances suivant un des quatre premiers condensateurs, respectivement dans une boucle en série.

3. Filtre polyphasé selon la revendication 2,
   dans lequel un produit de la valeur de résistance par la valeur de capacitance est sensiblement égal à un rapport d'un divisé par une fréquence de fonctionnement choisie, lorsque la fréquence de fonctionnement est exprimée en radians.

4. Filtre polyphasé selon la revendication 1 ou 2, dans lequel le deuxième déphaseur (14) comprend :

   quatre deuxièmes résistances d'une valeur de résistance sensiblement égale ; et quatre deuxièmes condensateurs d'une valeur de capacitance sensiblement égale, chacune des quatre deuxièmes résistances suivant une des quatre deuxièmes condensateurs, respectivement, dans une boucle en série ; et
   le troisième déphaseur (16) comprend: quatre troisièmes résistances d'une valeur de résistance sensiblement égale ; et quatre troisièmes condensateurs d'une valeur de capacitance sensiblement égale ; chacune des quatre troisièmes résistances suivant un des quatre troisièmes condensateurs, respectivement, dans une boucle en série.

5. Filtre polyphasé selon la revendication 4, dans lequel un produit de tan 22,5 degrés par la valeur de résistance des deuxièmes résistances par la valeur de capacitance des deuxièmes condensateurs est sensiblement égal à un rapport d'un divisé par une fréquence de fonctionnement choisie, lorsque la fréquence de fonctionnement est exprimée en radians ; et un produit de tan 67,5 degrés par la valeur de résistance des troisièmes résistances par la valeur de capacitance des troisièmes condensateurs est sensiblement égal à un rapport d'un divisé par une fréquence de fonctionnement choisie, lorsque la fréquence de fonctionnement est exprimée en radians.

6. Filtre polyphasé selon la revendication 4, dans lequel :

la valeur de résistance des deuxièmes résistances par la valeur de capacitance des deuxièmes condensateurs définit un deuxième produit ;

la valeur de résistance des troisièmes résistances par la valeur de capacitance des troisièmes condensateurs définit un troisième produit ;

un rapport du deuxième produit divisé par le troisième produit est sensiblement égal à un rapport de tan 67,5 degrés divisé par tan 22,5 degrés ; et

un produit du deuxième produit par le troisième produit est sensiblement égal à un rapport d'un divisé par un carré d'une fréquence de fonctionnement choisie, lorsque la fréquence de fonctionnement est exprimée en radians.

7. Procédé de déphasage de signal, le procédé comprenant les étapes de :

déphasage de deux signaux en quatre signaux intermédiaires à l'aide d'un premier déphaseur, les deux signaux étant d'une amplitude sensiblement égale et déphasés de sensiblement 180 degrés l'un par rapport à l'autre, et chacun des quatre signaux intermédiaires étant d'une amplitude sensiblement égale et déphasés de sensiblement 90 degrés l'un par rapport à l'autre ; et

conversion des quatre signaux intermédiaires en un premier groupe de quatre signaux de sortie avec un deuxième déphaseur, les quatre signaux de sortie étant d'une amplitude sensiblement égale et étant déphasés de sensiblement 90 degrés par rapport aux autres signaux de sortie dans le premier groupe ;

conversion des quatre signaux intermédiaires en un deuxième groupe de quatre signaux de sortie avec un troisième déphaseur, les quatre signaux de sortie étant d'une amplitude sensiblement égale et étant déphasés de sensiblement 90 degrés par rapport aux autres signaux de sortie dans le deuxième groupe ;

chacun des signaux de sortie du premier groupe étant déphasé de sensiblement 45 degrés par rapport à un signal de sortie respectif dans le deuxième groupe, chacun des premier, deuxième et troisième déphaseurs comprenant quatre résistances et quatre condensateurs dans une boucle en série, chacune des quatre résistances étant suivie dans la boucle en série par un des quatre condensateurs, respectivement.

8. Procédé selon la revendication 7, comprenant en outre l'utilisation d'un deuxième des deux signaux par l'inversion d'un premier des deux signaux.

9. Procédé selon la revendication 7 ou 8, dans lequel l'étape de déphasage comprend :
l'entrée de deux signaux vers un premier déphaseur quatre phases 90 degrés, où le premier déphaseur comprend quatre premières résistances et quatre premiers condensateurs dans une boucle en série, chacune des quatre premières résistances étant suivie dans la boucle en série par un des quatre premiers condensateurs, respectivement, les quatre premières résistances étant d'une valeur de résistance sensiblement égale, et les quatre premiers condensateurs étant d'une valeur de capacitance sensiblement égale.

10. Procédé selon la revendication 9, dans lequel un produit de valeur de résistance par la valeur de capacitance est sensiblement égal à un rapport d'un divisé par une fréquence de fonctionnement choisie lorsque la fréquence de fonctionnement est exprimée en radians.

11. Procédé selon l'une quelconque des revendications 7 à 10, dans lequel l'étape de conversion comprend en outre :

l'entrée des quatre signaux intermédiaires vers un deuxième déphaseur quatre phases 90 degrés ; et
l'entrée des quatre signaux vers un troisième déphaseur quatre phases 90 degrés.

12. Procédé selon la revendication 11, dans lequel le deuxième déphaseur comprend quatre deuxièmes résistances et quatre deuxièmes condensateurs dans une boucle en série, chacune des quatre deuxièmes résistances étant suivie dans la boucle en série par un des quatre deuxièmes condensateurs, respectivement, les quatre deuxièmes résistances étant d'une valeur de résistance sensiblement égale, et les quatre deuxièmes condensateurs étant d'une valeur de capacitance sensiblement égale ; et où le troisième déphaseur comprend quatre troisièmes résistances et quatre troisièmes condensateurs dans une boucle en série, chacune des quatre troisièmes résistances étant suivie dans la boucle en série par un des quatre troisièmes condensateurs, respectivement, les quatre troisièmes résistances étant d'une valeur de résistance sensiblement égale, et les quatre troisièmes condensateurs étant d'une valeur de capacitance sensiblement égale.

13. Procédé selon la revendication 12, dans lequel un produit de tan 22,5 degrés par la valeur de résistance des deuxièmes résistances par la valeur de capacitance des deuxièmes condensateurs est sensiblement égal à un rapport d'un divisé par une fréquence de fonctionnement choisie lorsque la fréquence de fonctionnement est exprimée en radians ; et un produit de tan 67,5 degrés par la valeur de résistance des troisièmes résistances par la valeur de capacitance des troisièmes condensateurs est sensiblement égal à un rapport d'un divisé par une fréquence de fonctionnement choisie lorsque la fréquence de fonctionnement est exprimée en radians.

14. Procédé selon la revendication 12, dans lequel un deuxième produit de la valeur de résistance des deuxièmes résistances par la valeur de capacitance des deuxièmes condensateurs, et un troisième produit, de la valeur de résistance des troisièmes résistances par la valeur de capacitance des troisièmes condensateurs, donnent : un rapport du deuxième produit divisé par le troisième produit étant sensiblement égal à un rapport de tan 67,5 degrés divisé par tan 22,5 degrés ; et un produit du deuxième produit par le troisième produit étant sensiblement égal à un divisé par un carré d'une fréquence de fonctionnement choisie lorsque la fréquence de fonctionnement est exprimée en radians.

_Fig. 1_

_Prior Art_

$$\mathbf{I}\left(\frac{1}{j\omega C}\right)$$

_Fig. 2_

_Fig. 3_

_Prior Art_

*Fig. 4*

*Fig. 5*

*Fig. 6*

*Fig. 7*

*Fig. 8*

*Fig. 9a*

*Fig. 9b*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3530365 A

- US 4647843 A